# EUROPEAN PATENT SPECIFICATION

(11) **EP 1 584 222 B1**
(45) Date of publication and mention of the grant of the patent: **03.05.2006**
(21) Application number: 04701369.3
(22) Date of filing: 12.01.2004
(51) Int. Cl.: H05K 1/18, G03B 17/02

(54) **PLACEMENT OF A CAMERA MODULE IN A PORTABLE DEVICE**
PLAZIERUNG EINES KAMERAMODULS IN EINEM TRAGBAREN GERÄT
PLACEMENT D'UN MODULE DE CAMERA DANS UN DISPOSITIF PORTABLE

(30) Priority: 17.01.2003 FI 20030071
(43) Date of publication of application: 12.10.2005
(73) Proprietor: Nokia Corporation, 02150 Espoo (FI)
(72) Inventor: HAAVISTO, Janne, FI-36200 Kangasala (FI); HILTUNEN, Jari, FI-37200 Siuro (FI)
(74) Representative: Rahkonen, Erkki Juhani
(86) International application number: PCT/FI2004/000014
(87) International publication number: WO 2004/066692

(56) References cited:
- EP-A1- 1 148 716
- US-A1- 2002 065 102
- PATENT ABSTRACTS OF JAPAN vol. 199, no. 912 29 October 1999 & JP 11 191 865 A 13 July 1999

## Description

The invention relates to a portable electronic device according to the preamble of claim 1. The invention also relates to a method according to the preamble of the appended claim 6 for placing a camera module in a portable electronic device. In addition, the invention relates to printed wiring board and the connected frame structure according to the preamble of the appended claim 10. The invention also relates to a frame structure according to the preamble of claim 14 and a camera module according to the preamble of claim 18.

With some mobile devices it is possible to take digital pictures of the surroundings, which pictures can, in some applications, be transferred to other devices via a mobile communication network. In order to take pictures, the device must include a camera function, which typically comprises a camera module and the necessary image processing means. The camera modules, for their part, comprise typically optical structures and electric structures. The optics of a camera module can consist of one or more lenses, which form, through an input aperture, a visible image on a suitable electronic means, such as a CCD cell (charge-coupled-device) or a CMOS cell (Complementary Metal Oxide Semiconductor). In addition, the optics of a camera module may comprise other parts, which affect the formation of the image, such as, for example, an aperture diaphragm.

Typically the camera module is installed on a printed wiring board after the assembly and soldering of other components, because of the thermal stability of the materials typically used in the camera modules, which in many cases is smaller than the temperature used in connection process of other components. In the known camera module structures meant to be installed in printed wiring boards, there are contacts for connecting the camera, typically either at the end of a flexible structure (a so-called flex-type connection), or the contacts are at the bottom of the camera module, i.e. on the opposite side of the lens structure of the module.

In a flex-type structure, wherein the contacts of the connector are placed at the ends of a flexible structure, it is possible to form the module relatively small, when the connection means are placed elsewhere. The frame part of a camera module, shaped as in question, is attached to the remaining structure of the device typically by gluing. The flex-type structure suits a quick-tempo assembly poorly because of, among other things, the characteristics of a flexible connection structure and the attachment work required by both the frame part and connector structure.

The camera modules, wherein the contacts are located at the bottom of the module, are placed on a printed wiring board typically by means of a separate connector part. Thus, the connector part is placed and connected on the printed wiring board simultaneously with other components. After a working phase that needs heat transfer, a camera module; whose connectors correspond to the contacts of the connector part, is installed in the frame. Thanks to a separate connector part, the camera module is easily detached and, if necessary, changed. On the other hand, the connector part situated between the camera module and printed wiring board increases the height of the structure.

From a Japanese publication JP2002185827A is known a camera structure, wherein the connectors to be placed against the printed wiring board are at the bottom. The structure according to the publication makes it possible to install a camera module on a printed wiring board without a separate connector part, because of which it is possible to make the structure of the component even lower. As a result of the lack of a separate connector part, replacing the component is, for example during maintenance, more troublesome than with solutions carried out with a connector part.

The present invention discloses a camera module structure, which enables a low overall structure.

The publication EP-A1-1148716 discloses an imaging device as defined in the preamble of claim 1. The portable electronic device according to the /T invention is primarily characterized in what will be presented in the characterizing part of the independent claim 1.

The invention further relates to a method for placing a camera module in a portable electronic device, which is primarily characterized in what will be presented in the characterizing part of the independent claim 6.

The invention further relates to a printed wiring board and a frame structure connected to it, which is primarily characterized in what will be presented in the characterizing part of the independent claim 10. The invention also relates to a frame structure, which is primarily characterized in what will be presented in the characterizing part of the independent claim 14, and a camera module according to the invention, which is, for its part, primarily characterized in what will be presented in the independent claim 18.

The other, dependent claims will present some preferred embodiments of the invention.

In the embodiments of the invention, the camera module can be installed on the printed wiring board in such a manner that the input aperture of the camera, i.e. typically a lens aperture, is on the other side of the printed wiring board from the connectors of the camera module. There must be an aperture in the printed wiring board, where the optics zone of the camera module can be placed. Preferably, the optics zone of the camera module is smaller by its diameter than the connector zone, in which case during installation the camera module leans on the widening of the connector zone. Preferably, the camera module is connected to an adapter part, wherein there are contacts corresponding to the contacts of the camera module. The adapter part is advantageously a frame-like structure, which settles on the level of the printed wiring board around the connector zone of the camera module. The contacts of the connector zone of the camera module settle, in the first embodiment according to the invention, on the printed wiring board side of the connector zone. In another embodiment, the contacts are located on one or more optical axis direction sides of the camera module.

In one advantageous embodiment according to the invention, the camera module can be easily installed in assembly and, if necessary, also after the other components have been attached. In addition, it is advantageous from the assembly point of view for the optics of the camera module to settle downwards, because then the risk of damage decreases significantly.

The embodiments of the invention makes it possible to form the device lower than before, because when the camera module settles on both sides of the printed wiring board, the camera module utilizes the space required for installing other components, as well as the space required by the thickness of the printed wiring board. The advantage becomes especially apparent in those applications of the embodiments, wherein the camera module is one of the largest components placed on the printed wiring board and other components are placed on both sides of the printed wiring board.

In some embodiments of the invention, the camera module is easily protected from mechanical and electrical interferences. It is possible to easily encase the camera module from the connector side, because no lead-ins or other special structures are required for the optics and the back surface of the module is substantially even.

A camera module according to embodiments of the invention is easily supported, because the springback factor of the spring-like connectors on the sides of the connector zone can be used to press the module towards the printed wiring board.

In the following, the invention will be described in more detail with reference to the principle drawings, in which
- Fig. 1: shows a frame structure according to an embodiment of the invention in a side view,
- Fig. 2: shows an embodiment of a camera module according to Fig. 1 from the lens aperture side,
- Fig. 3: shows a frame structure according to another embodiment of the invention in a side view,
- Fig. 4: shows an embodiment of a camera module according to Fig. 3 from the lens aperture side,
- Fig. 5: shows a frame structure according to a third embodiment of the invention in a side view, and
- Fig. 6: shows a frame structure according to a fourth embodiment of the invention in a side view.

For the sake of clarity, the figures only show the details required for understanding the invention. The structures and details which are not necessary for understanding the invention but which are obvious for anyone skilled in the art, have been omitted from the figures in order to emphasize the characteristics of the invention.

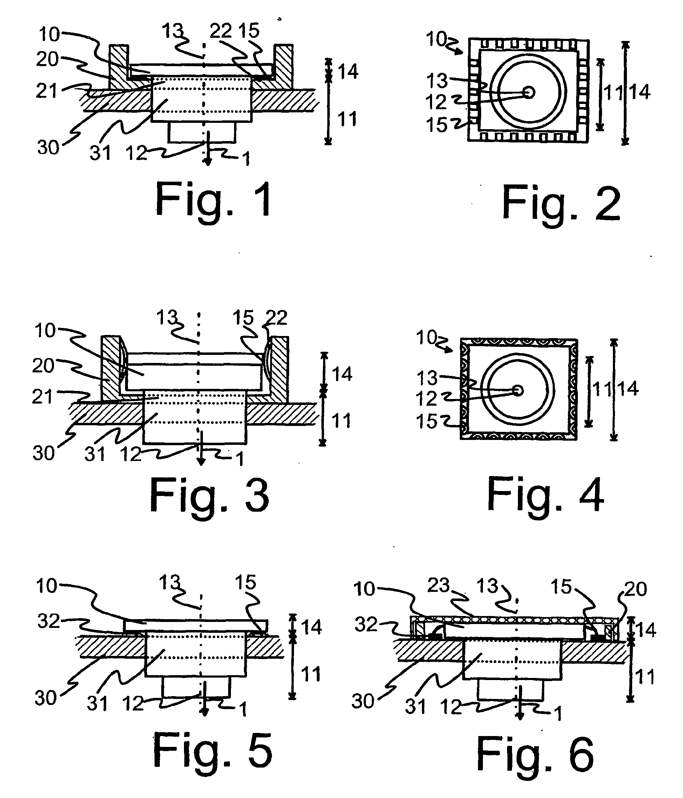

In an advantageous embodiment of the invention, the camera module 10 is placed in a frame 20 arranged on the printed wiring board 30, and other components required in the device are also arranged on the same printed wiring board, such as components required for data transfer or data editing in a mobile device. Some camera module structures 10 and frame structures 20 according to the embodiment in question are shown in figures 1-4 in principle.

The camera module 10 comprises different functional components, which in this description are referred to as zones. In addition to the optics zone 11 and the connector zone 14, the camera module 10 comprises other zones and components, such as a CCD cell or a CMOS cell, which are not separately shown in the figures.

The optics zone 11 comprises, for optical forming of an image, at least a lens structure opening to the direction of function 1 through an input aperture 12, which structure can consist of one or more lenses. The input aperture 12 here refers to the foremost free area of an optical component, which may be an aperture or the surface of a lens.

Through the input aperture 12, i.e. typically the lens aperture, runs a so-called optical axis 13, which is parallel to the direction of function 1 of the camera module 10, from the recorded object through the lens structure to the image sensor, i.e. typically a CMOS cell or CCD cell.

In order to transfer data between the camera module 10 and other equipment, there is a connector zone 14 in the camera module. The connector zone 14 comprises at least contacts 15, with which the camera module 10 is electrically connected to the electric circuit of the rest of the equipment. In addition, in the connector zone 14 there can advantageously be elements for mechanical attachment of the camera module 10, which elements are preferably the same elements as the contacts 15 meant for electric connection. The number of contacts 15 depends mostly on the characteristics of the cell of the camera module 10, and this invention is not dependent on the number of contacts.

The camera module 10 according to an embodiment of the invention is placed into the frame 20 connected to the printed wiring board 30 in such a manner that the optics zone 11 of the camera module settles substantially inside the frame and through the printed wiring board. Thus, the frame 20 comprises at least an aperture 21 for the optics zone 11, as well as counter-contacts 22 corresponding to the contacts 15 of the camera module 10 and connection elements for connecting to the printed wiring board 30. In addition, there can advantageously be elements for mechanical attachment of the camera module 10 in the frame 20, which elements are preferably the same elements as the counter-contacts 22.

The printed wiring board 30 is typically multi-layered, but the structure of the printed wiring board can vary extensively without the basic idea of the invention changing. The frame 20 according to the invention is connected to the printed wiring board 30 in such a manner that the aperture 21 of the frame and the aperture 31 in the printed wiring board are aligned, in which case the optical axis 13 of the camera module 10 can be arranged through the apertures in question, in which case the direction 1 of function of the camera module forms on the other side of the printed wiring board, while the frame settles on the first side of the printed wiring board. In addition, other components and elements required in the equipment, which are typically placed on both sides of the printed wiring board, are connected to the printed wiring board 30.

The contacts 15, 22 of the camera module 10 according to the invention and the frame 20 can be formed in many different ways. Preferably the contacts 15, 22 are arranged according to either image pair 1 and 2 or 3 and 4.

In one embodiment of the invention presented in figures 1 and 2, the contacts 15, which are on a perpendicular plane in relation to the optical axis 13 of the camera module 10, are on the side of the optics zone 11 side of the connector zone 14. The contacts 15 can be formed according to the example on each side of the optical axis 13 of the camera module 10, or there can be contacts on one or more sides.

Thus, the counter-contacts 22, which settle against the contacts 15 of the camera module 10 of the frame 20, are according to the figure 1 on the same plane, which is substantially parallel to the plane formed by the printed wiring board 30.

The contact elements 15, 22 of both the camera module 10 and the frame 20 can be implemented in several different ways. It is, however, advantageous, that either the contacts 15 of the camera module 10, or preferably the counter-contacts 22 of the frame 20, are flexible, such as clip-like, in which case there is loading force between the contacts of the camera module and the frame. Thus, the electric connection between the camera module 10 and the frame 20 remains during the possible temporary shifts of the components as well, such as, for example, during the effect of and outside vibration.

In another embodiment of the invention shown on figures 3 and 4, the contacts 15 of the camera module 10 are on the sides parallel to the direction of the optical axis 13 of the connector zone 14. Also in this embodiment, the contacts 15 can be on one or more sides, for example on every side parallel to the direction of the optical axis 13 according to the example in figure 4.

In this embodiment as well, the contact elements 15, 22 of the camera module 10 and the frame 20 can be implemented in several different ways. It is, however, advantageous, because of the reasons presented in connection with the previous embodiment, that either the contacts 15 of the camera module 10 or preferably the counter-contacts 22 of the frame 20 are flexible, such as clip-like, in which case there is loading force between the contacts of the camera module and the frame. In addition, in the embodiment in question, it is possible to utilize said loading force in keeping the camera module 10 in place. Preferably the counter-contacts 22 of the frame 20 are arranged on each side in such a manner that the loading force created by their spring-like structure is aimed at the camera module 10 in such a manner that a force pressing the module towards the printed wiring board 30 is aimed at it.

A combination of the above-presented contact arrangements 15, 22 is also possible and the manner in question is advantageous when considerably many contacts are required in the camera module 10.

An embodiment according to the invention is shown in figure 5. In the example in question, the camera module 10 is substantially the same as the camera module 10 in figure 1, i.e. the contacts 15 of the camera module are on the side of the optics zone 11 of the connector zone 14 on a perpendicular plane in relation to the optical axis 13 of the camera module 10. The counter-contacts 22 of the frame 20 presented in figure 1 are, in this embodiment, arranged directly on the printed wiring board 30. Thus, the contacts 15 of the camera module 10 settle against the counter-contacts, which in this embodiment are the counter-contacts 32 arranged to the printed wiring board 30. Attachment of the camera module 10 can be implemented, for its part, in several different ways, such as, for example, by gluing or with an appropriate attachment element.

Another embodiment according to the invention is shown in figure 6. In the example in question, the contact 15 of the camera module 10 is in the connector zone 14 at the end of a lead coming out form component bodv i.e package. The contact surface of the contact 15 is placed in the connector zone 14 on the optics zone 11 side on a perpendicular plane in relation to the optical axis 13 of the camera module 10. Thus, the contacts 15 of the camera module 10 settle against the counter-contacts, which in this embodiment are the counter-contacts 32 arranged to the printed wiring board 30, just as in the previous example. The contacts 15 of the camera module 10 are attached to the counter-contacts 32 in an appropriate manner, such as, for example, by soldering or by gluing. In an embodiment the contacts 15 of the camera module 10 are spring-like, in which case the attachment can be implemented with a springback factor. Thus, the camera module 10 is placed in its position in such a manner that the contacts 15 of the camera module are pressed against the counter-contacts 32. Attachment of the camera module 10 can be implemented in several different ways as well, such as, for example, by gluing or with an appropriate attachment element. In an embodiment the attachment of the camera module 10 is implemented by means of a protective shell 23. Thus, the protective shell 23 attaches to a wiring board 30 either directly or by means of a frame 20, in which case the camera module settling between the protective shield and the wiring board remains in its position.

In the placement of the contacts 15, 22, 32 according to the invention there are no contacts on the opposite side of the direction 1 of function of the camera module 10 (i.e. the light aperture 12). Thus, the protection of the camera module 10 against electromagnetic radiation is easy to implement. The protection can be implemented either as a part of the camera module 10 and the frame 20, or the protection can be arranged with a separate protection element, such as a protective shell 23 or a protective plate. An advantageous manner, from the point of view of assembly, is to form the frame 20 from such suitable material, which limits the electromagnetic interference radiation. Those areas of the camera module 10, which settle outside the possible frame 20 when the camera modules are fitted to the frame, are, for their part, advantageous to coat or otherwise form of a material which attenuates radiation. Similarly, it is advantageous to coat or otherwise form of radiation attenuating materials parts of or the entire camera module 10 in the frameless embodiment presented in figure 5. Thus, in the assembly, the interference protection is formed without separate procedures during the installation of the components.

By combining, in various ways, the modes and structures presented in connection with the different embodiments of the invention presented above, it is possible to produce various embodiments of the invention. Therefore, the above-presented examples must not be interpreted as restrictive to the invention, but the embodiments of the invention can be freely varied within the scope of the inventive features presented in the claims hereinbelow.

## Claims

1. A portable electronic device, comprising
- a camera module (10), which comprises an optics zone (11) having an input aperture (12) and a connector zone (14), and
- a printed wiring board (30), which includes parallel first and second sides for placing the camera module (10) and other structures, in such a manner that the optics zone (11) and the connector zone (14) of the camera module (10) are settled on different sides of the printed wiring board (30),
**characterized in that** the connector zone (14) comprises
- contacts (15) for connecting the camera module (10) electrically to the counter-contacts (22, 32), and
- elements for mechanical attachment of the camera module (10)
in such a manner that at least some of the elements for mechanical attachment are the same elements as the contacts (15) meant for the electric connection.

2. The device according to claim 1, **characterized in that** at least a part of the contacts (15) and counter-contacts (22, 32) are arranged in such a manner that there is a loading force between said contacts (15) and counter-contacts (22, 32) in order to attach the camera module.

3. The device according to claim 2, **characterized in that** the loading force is created by spring-like contact means (15, 22, 32).

4. The device according to any of the claims 1 to 3, **characterized in that** the device comprises, in addition, at least a frame structure (20), which comprises at least
- contacts (22) for connecting the camera module (10),
- an aperture (21), which is on the side placed against the printed wiring board (30) in the frame structure, and
the optics zone (11) of the camera module (10) is placed at least partly inside the aperture (21) of the frame structure (20).

5. The device according to one of the claims 1 to 4, **characterized in that** the device is arranged to transfer data in a wireless manner.

6. A method for placing a camera module (10) in a portable electronic device, wherein the camera module (10), which comprises an input aperture (12) and a connector zone (14), is arranged on a printed wiring board (30) of the device in such a manner that the input aperture (12) of the camera module (10) settles on a different side of printed wiring board (30) than the connector zone (14), **characterized in that** the connector zone (14) comprises contacts (15) connecting the camera module (10) electrically to the counter-contacts (22, 32), wherein at least a part of the contacts (15) attach the camera module electrically and mechanically.

7. The method according to claim 6, **characterized in that** there is a loading force between at least some contacts (15) and counter-contacts (22, 32) in order to attach the camera module.

8. The method according to claim 7, **characterized in that** the loading force is created by spring-like contact means (15, 22, 32).

9. The method according to any of the claims 6 to 8, **characterized in that** the camera module (10) is arranged on the printed wiring board (30) via the frame structure (20), and the printed wiring board (30) comprises at least an aperture (31) penetrating the printed wiring board, and the frame structure (20) comprises at least an aperture (21) on the side settling against the printed wiring board (30), and said apertures (31, 21) are placed one on the other in such a manner that the camera module (10) can be placed at least partly inside the aperture (31) of said printed wiring board and the aperture (21) of said frame structure.

10. A printed wiring board (30) and a frame structure (20) connected to it for installing a camera module (10), wherein
- the printed wiring board (30) has an aperture (31), and
- the frame structure has an aperture (21) on a side placed against the printed wiring board (30),
- said apertures (21, 31) being placed in such a manner that at least a part of the camera module (10) can be placed through the aperture (21) of the frame structure (20) to the aperture (31) of the printed wiring board (30),
**characterized in that** the frame structure (20) has
- contacts (22) for connecting the camera module (10) electrically to the the frame structure (20), and
- elements for mechanical attachment of the camera module (10),
in such a manner that at least some of the elements for mechanical attachment are the same elements as the contacts (22) meant for the electric connection.

11. The printed wiring board (30) and a frame structure (20) connected to it according to claim 10, **characterized in that** at least a part of the contacts (22) of the frame structure (20) and corresponding contacts (15) of the camera module (10) are arranged in such a manner that there is a loading force between said contacts (15, 22) in order to attach the camera module.

12. The printed wiring board (30) and the frame structure. (20) connected to it according to claim 11, **characterized in that** the loading force is created by spring-like contact means (15, 22).

13. A printed wiring board (30) and a frame structure (20) connected to it according to any of the claims 10 to 12, **characterized in that** there are contacts (22) in the frame structure (20) for connecting the camera module (10), which are placed on
- at least the side parallel to the direction of the printed wiring board (30), or
- at least one side, which is substantially perpendicular in relation to the printed wiring board (30), or
- at least a first side parallel to the direction of the printed wiring board (30) and a second side, which is substantially perpendicular in relation to the printed wiring board.

14. A frame structure (20) to be placed on a printed wiring board (30) for placing a camera module (10), which frame structure comprises an installation aperture on a first side for placing the camera module (10) in the frame structure (20),
**characterized in that** the frame structure comprises
- contacts (22) for connecting the camera module (10) to the frame structure (20) electrically and
- elements for mechanical attachment of the camera module (10),
in such a manner that at least some of the elements for mechanical attachment are the same elements as the contacts (22) meant for the electric connection.

15. The frame structure (20) according to claim 14, **characterized in that** at least a part of the contacts (22) of the frame structure (20) and the contacts (15) of the camera module (10) are arranged in such a manner that there is a loading force between said contacts (15, 22) in order to attach the camera module.

16. The frame structure (20) according to claim 15, **characterized in that** the loading force is created by spring-like contact means (15, 22).

17. The frame structure (20) according to any of the claims 14 to 16, **characterized in that** the contacts (22) of the frame structure (20) are placed on
- at least the same side as the aperture (21), or
- at least one side, which is substantially perpendicular to the side comprising the aperture (21), or
- at least the same first side with the aperture (21) and the second side, which is substantially perpendicular to the first side.

18. A camera module (10) that can be placed on a printed wiring board (30), which camera module (10) comprises
- an optics zone (11) having an input aperture (12) and
- a connector zone (14),
the camera module (10) having a direction (1) of function, which is substantially the same as a direction of the input aperture (12) from the connector zone (14), and the optics zone (11) of the camera module (10) can be placed at least partly through the printed wiring board (30),
**characterized in that** the connector zone (14) comprises
- contacts (15) for connecting the camera module (10) electrically to counter-contacts (22, 32), and
- elements for mechanical attachment of the camera module (10),
in such a manner that at least some of the elements for mechanical attachment are the same elements as the contacts (15) meant for the electric connection.

19. The camera module according to claim 18, **characterized in that** the contacts (15) are placed in the connector zone (14) on
- at least one side parallel with the direction (1) of function of the camera module (10), or
- at least on the side of the light aperture (12) of the optics zone (11), or
- at least one side parallel with the direction (1) of function of the camera module (10) and on the side of the light aperture (12) of the optics zone (11).

## Patentansprüche

1. Tragbare elektronische Vorrichtung, umfassend
- ein Kameramodul (10), welches einen Optikbereich (11) umfasst, der eine Eingangsöffnung (12) und einen Verbindungsbereich (14) aufweist, und
- eine gedruckte Leiterplatte (30), die parallele erste und zweite Seiten zum Anbringen des Kameramoduls (10) und weiterer Strukturen derart aufweist, dass der Optikbereich (11) und der Verbindungsbereich (14) des Kameramoduls (10) auf verschiedenen Seiten der gedruckten Leiterplatte (30) angeordnet sind,
**dadurch gekennzeichnet, dass** der Verbindungsbereich (14)
- Kontakte (15), um das Kameramodul (10) elektrisch an die Gegenkontakte (22, 32) anzuschließen, und
- Elemente für das mechanische Befestigen des Kameramoduls (10)
derart umfasst, dass mindestens einige der Elemente zum mechanischen Befestigen dieselben Elemente sind wie die Kontakte (15), die für den elektrischen Anschluss vorgesehen sind.

2. Vorrichtung nach Anspruch 1, **dadurch gekennzeichnet**, das mindestens ein Teil der Kontakte (15) und der Gegenkontakte (22, 32) derart angeordnet ist, dass es eine Spannkraft zwischen den Kontakten (15) und den Gegenkontakten (22, 32) gibt, um das Kameramodul zu befestigen.

3. Vorrichtung nach Anspruch 2, **dadurch gekennzeichnet, dass** die Spannkraft durch federartige Kontaktmittel (15, 22, 32) erzeugt wird.

4. Vorrichtung nach einem der Ansprüche 1 bis 3, **dadurch gekennzeichnet, dass** die Vorrichtung zusätzlich mindestens eine Rahmenstruktur (20) aufweist, welche mindestens umfasst
- Kontakte (22) zum Anschließen des Kameramoduls (10),
- eine Öffnung (21), welche in der Rahmenstruktur auf der Seite ist, die der gedruckten Leiterplatte (30) gegenüberliegt, und
der Optikbereich (11) des Kameramoduls (10) mindestens teilweise innerhalb der Öffnung (21) der Rahmenstruktur (20) angeordnet ist.

5. Vorrichtung nach einem der Ansprüche 1 bis 4, **dadurch gekennzeichnet, dass** die Vorrichtung eingerichtet ist, Daten mit einem drahtlosen Verfahren zu übertragen.

6. Verfahren zum Anbringen eines Kameramoduls (10) in einer tragbaren elektronischen Vorrichtung, wobei das Kameramodul (10), das eine Eingangsöffnung (12) und einen Verbindungsbereich (14) umfasst, auf einer gedruckten Leiterplatte (30) der Vorrichtung derart angeordnet ist, das die Eingangsöffnung (12) des Kameramoduls (10) auf einer anderen Seite der gedruckten Leiterplatte (30) als der Verbindungsbereich (14) angeordnet ist, **dadurch gekennzeichnet, dass** der Verbindungsbereich (14) Kontakte (15) umfasst, welche das Kameramodul (10) elektrisch an die Gegenkontakte (22, 32) anschließen, wobei mindestens ein Teil der Kontakte (15) das Kameramodul elektrisch und mechanisch anbindet.

7. Verfahren nach Anspruch 6, **dadurch gekennzeichnet**, das es eine Spannkraft zwischen mindestens einigen Kontakten (15) und Gegenkontakten (22, 32) gibt, um das Kameramodul festzuhalten.

8. Verfahren nach Anspruch 7, **dadurch gekennzeichnet, dass** die Spannkraft durch federartige Kontaktmittel (15, 22, 32) erzeugt wird.

9. Verfahren nach einem der Ansprüche 6 bis 8, **dadurch gekennzeichnet, dass** das Kameramodul (10) mittels der Rahmenstruktur (20) auf der gedruckten Leiterplatte (30) angebracht ist und die gedruckte Leiterplatte (30) mindestens eine Öffnung (31) aufweist, welche die gedruckte Leiterplatte durchdringt, und die Rahmenstruktur (20) mindestens eine Öffnung (21) auf der Seite aufweist, die der gedruckten Leiterplatte (30) gegenüberliegt, und die Öffnungen (31, 21) derart eine über der anderen angeordnet sind, dass das Kameramodul (10) mindestens teilweise innerhalb der Öffnung (31) der gedruckten Leiterplatte und der Öffnung (21) der Rahmenstruktur angeordnet werden kann.

10. Gedruckte Leiterplatte (30) und eine mit ihr verbundene Rahmenstruktur (20) zum Einbauen eines Kameramoduls (10), wobei
- die gedruckte Leiterplatte (30) eine Öffnung (31) aufweist und
- die Rahmenstruktur eine Öffnung (21) auf einer Seite aufweist, welche der gedruckten Leiterplatte (30) gegenüberliegt,
- die Öffnungen (21, 31) derart angeordnet sind, dass mindestens ein Teil des Kameramoduls (10) durch die Öffnung (21) der Rahmenstruktur (20) zur Öffnung (31) der gedruckten Leiterplatte (30) hin eingesetzt werden kann,
**dadurch gekennzeichnet, dass** die Rahmenstruktur (20)
- Kontakte (22), um das Kameramodul (10) elektrisch an die Rahmenstruktur (20) anzuschließen, und
- Elemente für das mechanische Befestigen des Kameramoduls (10)
derart aufweist, dass mindestens einige der Elemente zum mechanischen Befestigen dieselben Elemente sind wie die Kontakte (22), die für den elektrischen Anschluss vorgesehen sind.

11. Gedruckte Leiterplatte (30) und eine mit ihr verbundene Rahmenstruktur (20) nach Anspruch 10, **dadurch gekennzeichnet, dass** mindestens ein Teil der Kontakte (22) der Rahmenstruktur (20) und der entsprechenden Kontakte (15) des Kameramoduls (10) derart angeordnet sind, dass es eine Spannkraft zwischen den Kontakten (15, 22) gibt, um das Kameramodul zu befestigen.

12. Gedruckte Leiterplatte (30) und die mit ihr verbundene Rahmenstruktur (20) nach Anspruch 11, **dadurch gekennzeichnet, dass** die Spannkraft durch federartige Kontaktmittel (15, 22) erzeugt wird.

13. Gedruckte Leiterplatte (30) und die mit ihr verbundene Rahmenstruktur (20) nach einem der Ansprüche 10 bis 12, **dadurch gekennzeichnet, dass** es in der Rahmenstruktur (20) Kontakte (22) zum Anschließen des Kameramoduls (10) gibt, die angeordnet sind auf
- mindestens der Seite parallel zur Richtung der gedruckten Leiterplatte (30) oder
- mindestens der einen Seite, die weitgehend senkrecht mit Bezug auf die gedruckte Leiterplatte (30) ist oder
- mindestens einer ersten Seite parallel zur Richtung der gedruckten Leiterplatte (30) und einer zweiten Seite, die weitgehend senkrecht mit Bezug auf die gedruckte Leiterplatte ist.

14. Rahmenstruktur (20), die auf einer gedruckten Leiterplatte (30) anzuordnen ist, um ein Kameramodul (10) anzubringen, wobei die Rahmenstruktur eine Einbauöffnung auf einer ersten Seite für das Anordnen des Kameramoduls (10) in der Rahmenstruktur (20) aufweist,
**dadurch gekennzeichnet, dass** die Rahmenstruktur
- Kontakte (22), um das Kameramodul (10) elektrisch an die Rahmenstruktur (20) anzuschließen, und
- Elemente für das mechanische Befestigen des Kameramoduls (10)
derart aufweist, dass mindestens einige der Elemente zum mechanischen Befestigen dieselben Elemente sind wie die Kontakte (22), die für den elektrischen Anschluss vorgesehen sind.

15. Rahmenstruktur (20) nach Anspruch 14, **dadurch gekennzeichnet, dass** mindestens ein Teil der Kontakte (22) der Rahmenstruktur (20) und der Kontakte (15) des Kameramoduls (10) derart angeordnet ist, dass es eine Spannkraft zwischen den Kontakten (15,22) gibt, um das Kameramodul zu befestigen.

16. Rahmenstruktur (20) nach Anspruch 15, **dadurch gekennzeichnet, dass** die Spannkraft durch federartige Kontaktmittel (15, 22) erzeugt wird.

17. Rahmenstruktur (20) nach einem der Ansprüche 14 bis 16, **dadurch gekennzeichnet, dass** die Kontakte (22) der Rahmenstruktur (20) angeordnet sind auf
- mindestens derselben Seite wie die Öffnung (21) oder
- mindestens der einen Seite, die weitgehend senkrecht zu der Seite ist, welche die Öffnung (21) enthält oder
- mindestens derselben ersten Seite mit der Öffnung (21) und der zweiten Seite, die weitgehend senkrecht zu der ersten Seite ist.

18. Kameramodul (10), das auf einer gedruckten Leiterplatte (30) angeordnet werden kann, wobei das Kameramodul (10) umfasst
- einen Optikbereich (11), der eine Eingangsöffnung (12) aufweist, und
- einen Verbindungsbereich (14),
wobei das Kameramodul (10) eine Funktionsrichtung (1) aufweist, welche im Wesentlichen dieselbe ist wie die Richtung der Eingangsöffnung (12) aus der Verbindungszone (14), und der Optikbereich (11) des Kameramoduls (10) mindestens zum Teil durch die gedruckte Leiterplatte (30) hindurch eingesetzt werden kann,
**dadurch gekennzeichnet, dass** der Verbindungsbereich (14)
- Kontakte (15), um das Kameramodul (10) elektrisch an Gegenkontakte (22, 32) anzuschließen, und
- Elemente für das mechanische Befestigen des Kameramoduls (10)
derart umfasst, dass mindestens einige der Elemente zum mechanischen Befestigen dieselben Elemente sind wie die Kontakte (15), die für den elektrischen Anschluss vorgesehen sind.

19. Kameramodul nach Anspruch 18, **dadurch gekennzeichnet, dass** die Kontakte (15) im Verbindungsbereich (14) angeordnet sind auf
- mindestens der einen Seite parallel zur Funktionsrichtung (1) des Kameramoduls (10) oder
- mindestens der Seite der Lichtöffnung (12) des Optikbereichs (11) oder
- mindestens der einen Seite parallel zur Funktionsrichtung (1) des Kameramoduls (10) und auf der Seite der Lichtöffnung (12) des Optikbereichs (11).

## Revendications

1. Dispositif électronique portable, comprenant :
- un module d'appareil de prise de vues (10), qui comprend une zone d'optique (11) comportant une ouverture d'entrée (12) et une zone de connecteur (14), et
- une carte de circuit imprimé (30), qui comprend des premier et second côtés parallèles destinés à positionner le module d'appareil de prise de vues (10) et d'autres structures, de telle manière que la zone d'optique (11) et la zone de connecteur (14) du module d'appareil de prise de vues (10) soient installées sur des côtés différents de la carte de circuit imprimé (30),
**caractérisé en ce que** la zone de connecteur (14) comprend
- des contacts (15) destinés à connecter le module d'appareil de prise de vues (10) électriquement à des contre-contacts (22, 32), et
- des éléments destinés à une fixation mécanique du module d'appareil de prise de vues (10)
de telle manière qu'au moins certains des éléments destinés à la fixation mécanique sont les mêmes éléments que les contacts (15) prévus pour la connexion électrique.

2. Dispositif selon la revendication 1, **caractérisé en ce qu'**au moins une partie des contacts (15) et des contre-contacts (22, 32) sont disposés de telle manière qu'il existe une force de charge entre lesdits contacts (15) et lesdits contre-contacts (22, 32) de manière à fixer le module d'appareil de prise de vues.

3. Dispositif selon la revendication 2, **caractérisé en ce que** la force de charge est créée par des moyens de contact du type ressort (15, 22, 32).

4. Dispositif selon l'une quelconque des revendications 1 à 3, **caractérisé en ce que** le dispositif comprend, en outre, au moins une structure de châssis (20), qui comprend au moins
- des contacts (22) destinés à connecter le module d'appareil de prise de vues (10),
- une ouverture (21), qui est placée d'un côté contre la carte de circuit imprimé (30) dans la structure de châssis, et la zone d'optique (11) du module d'appareil de prise de vues (10) est positionnée au moins en partie à l'intérieur de l'ouverture (21) de la structure du châssis (20).

5. Dispositif selon l'une des revendications 1 à 4, **caractérisé en ce que** le dispositif est agencé pour transférer des données sans fil.

6. Procédé destiné à positionner un module d'appareil de prise de vues (10) dans un dispositif électronique portable, dans lequel le module d'appareil de prise de vues (10), qui comprend une ouverture d'entrée (12) et une zone de connecteur (14), est disposé sur une carte de circuit imprimé (30) du dispositif de telle manière que l'ouverture d'entrée (12) du module d'appareil de prise de vues (10) soit installée sur un côté différent de la carte de circuit imprimé (30) de celui de la zone de connecteur (14), **caractérisé en ce que** la zone de connecteur (14) comprend des contacts (15) connectant électriquement le module d'appareil de prise de vues (10) aux contre-contacts (22, 32), dans lequel au moins une partie des contacts (15) fixent le module d'appareil de prise de vues électriquement et mécaniquement.

7. Procédé selon la revendication 6, **caractérisé en ce qu'**il existe une force de charge entre au moins certains contacts (15) et contre-contacts (22, 32) de manière à fixer le module d'appareil de prise de vues.

8. Procédé selon la revendication 7, **caractérisé en ce que** la force de charge est créée par des moyens de contact du type ressort (15, 22, 32).

9. Procédé selon l'une quelconque des revendications 6 à 8, **caractérisé en ce que** le module d'appareil de prise de vues (10) est disposé sur la carte de circuit imprimé (30) par l'intermédiaire de la structure de châssis (20), et la carte de circuit imprimé (30) comprend au moins une ouverture (31) pénétrant dans la carte de circuit imprimé, et la structure de châssis (20) comprend au moins une ouverture (21) sur le côté reposant contre la carte de circuit imprimé (30), et lesdites ouvertures (31, 21) sont positionnées l'une sur l'autre de manière à ce que le module d'appareil de prise de vues (10) puisse être placé au moins partiellement à l'intérieur de l'ouverture (31) de ladite carte de circuit imprimé et à l'intérieur de l'ouverture (21) de ladite structure de châssis.

10. Carte de circuit imprimé (30) et structure de châssis (20) reliée à celle-ci, destinées à installer un module d'appareil de prise de vues (10), dans lesquelles
- la carte de circuit imprimé (30) comporte une ouverture (31), et
- la structure de châssis comporte une ouverture (21) sur un côté positionné contre la carte de circuit imprimé (30),
- lesdites ouvertures (21, 31) étant positionnées de telle manière qu'au moins une partie du module d'appareil de prise de vues (10) peut être positionnée à travers l'ouverture (21) de la structure de châssis (20) dans l'ouverture (31) de la carte de circuit imprimé (30),
**caractérisées en ce que** la structure de châssis (20) comporte
- des contacts (22) destinés à connecter le module d'appareil de prise de vues (10) électriquement à la structure de châssis (20), et
- des éléments destinés à une fixation mécanique du module d'appareil de prise de vues (10),
de telle manière qu'au moins certains des éléments destinés à une fixation mécanique sont les mêmes éléments que les contacts (22) prévus pour la connexion électrique.

11. Carte de circuit imprimé (30) et structure de châssis (20) reliée à celle-ci, selon la revendication 10, **caractérisées en ce qu'**au moins une partie des contacts (22) de la structure de châssis (20) et des contacts correspondants (15) du module d'appareil de prise de vues (10) sont agencés de telle manière qu'il existe une force de charge entre lesdits contacts (15, 22) afin de fixer le module d'appareil de prise de vues.

12. Carte de circuit imprimé (30) et structure de châssis (20) reliée à celle-ci, selon la revendication 11, **caractérisées en ce que** la force de charge est créée par des moyens de contact du type ressort (15, 22).

13. Carte de circuit imprimé (30) et structure de châssis (20) reliée à celle-ci, selon l'une quelconque des revendications 10 à 12, **caractérisées en ce qu'**il existe des contacts (22) dans la structure de châssis (20) pour une connexion du module d'appareil de prise de vues (10), qui sont positionnés sur
- au moins le côté parallèle à la direction de la carte de circuit imprimé (30), ou
- au moins un côté, qui est généralement perpendiculaire par rapport à la carte de circuit imprimé (30), ou
- au moins un premier côté parallèle à la direction de la carte de circuit imprimé (30) et un second côté, qui est sensiblement perpendiculaire par rapport à la carte de circuit imprimé.

14. Structure de châssis (20) devant être placée sur une carte de circuit imprimé (30) en vue de positionner un module d'appareil de prise de vues (10), laquelle structure de châssis comprend une ouverture d'installation sur un premier côté en vue de positionner le module d'appareil de prise de vues (10) dans la structure de châssis (20),
**caractérisée en ce que** la structure de châssis comprend
- des contacts (22) destinés à connecter électriquement le module d'appareil de prise de vues (10) à la structure de châssis (20) et
- des éléments destinés à une fixation mécanique du module d'appareil de prise de vues (10),
de telle manière qu'au moins certains des éléments destinés à une fixation mécanique sont les mêmes éléments que les contacts (22) prévus pour la connexion électrique.

15. Structure de châssis (20) selon la revendication 14, **caractérisée en ce qu'**au moins une partie des contacts (22) de la structure de châssis (20) et des contacts (15) du module d'appareil de prise de vues (10) sont disposés de telle manière qu'il existe une force de charge entre lesdits contacts (15, 22) de manière à fixer le module d'appareil de prise de vues.

16. Structure de châssis (20) selon la revendication 15, **caractérisée en ce que** la force de charge est créée par des moyens de contact du type ressort (15, 22).

17. Structure de châssis (20) selon l'une quelconque des revendications 14 à 16, **caractérisée en ce que** les contacts (22) de la structure de châssis (20) sont positionnés sur
- au moins le même côté que l'ouverture (21), ou
- au moins un côté, qui est sensiblement perpendiculaire au côté comprenant l'ouverture (21), ou
- au moins le même premier côté ayant l'ouverture (21) et le second côté, qui est sensiblement perpendiculaire au premier côté.

18. Module d'appareil de prise de vues (10) qui peut être positionné sur une carte de circuit imprimé (30), lequel module d'appareil de prise de vues (10) comprend
- une zone d'optique (11) comportant une ouverture d'entrée (12) et
- une zone de connecteur (14),
le module d'appareil de prise de vues (10) ayant une direction (1) de fonctionnement, qui est globalement la même direction que celle de l'ouverture d'entrée (12) par rapport à la zone de connecteur (14), et la zone d'optique (11) du module d'appareil de prise de vues (10) peut être située au moins partiellement à travers la carte de circuit imprimé (30), **caractérisé en ce que** la zone de connecteur (14) comprend
- des contacts (15) destinés à connecter le module d'appareil de prise de vues (10) électriquement aux contre-contacts (22, 32), et
- des éléments destinés à une fixation mécanique du module d'appareil de prise de vues (10),
de telle manière qu'au moins certains des éléments destinés à une fixation mécanique sont les mêmes éléments que les contacts (15) prévus pour la connexion électrique.

19. Module d'appareil de prise de vues selon la revendication 18, **caractérisé en ce que** les contacts (15) sont situés dans la zone de connecteur (14) sur
- au moins un premier côté parallèle à la direction (1) de fonctionnement du module d'appareil de prise de vues (10), ou
- au moins sur le côté de l'ouverture pour la lumière (12) de la zone d'optique (11), ou
- au moins un côté parallèle à la direction (1) de fonctionnement du module d'appareil de prise de vues (10) et sur le côté de l'ouverture pour la lumière (12) de la zone d'optique (11).
